# EUROPÄISCHE PATENTSCHRIFT

(11) **EP 1 514 459 B1**
(45) Veröffentlichungstag und Bekanntmachung des Hinweises auf die Patenterteilung: **13.07.2011**
(21) Anmeldenummer: 03727202.8
(22) Anmeldetag: 11.04.2003
(51) Int. Cl.: H05K 3/46

(54) **METALL-KERAMIK-SUBSTRAT FÜR ELEKTISCHE SCHALTKREISE- ODER MODULE, VERFAHREN ZUM HERSTELLEN EINES SOLCHEN SUBSTRATES SOWIE MODUL MIT EINEM SOLCHEN SUBSTRAT**
METAL-CERAMIC SUBSTRATE FOR ELECTRIC CIRCUITS OR MODULES, METHOD FOR PRODUCING ONE SUCH SUBSTRATE AND MODULE COMPRISING ONE SUCH SUBSTRATE
SUBSTRAT METAL-CERAMIQUE POUR CIRCUITS OU MODULES DE COMMUTATION ELECTRIQUES, PROCEDE DE PRODUCTION D'UN TEL SUBSTRAT ET MODULE POURVU D'UN TEL SUBSTRAT

(30) Priorität: 20.06.2002 DE 10227658
(43) Veröffentlichungstag der Anmeldung: 16.03.2005
(60) Teilanmeldung: 09014389.2
(73) Patentinhaber: Curamik Electronics GmbH, 92676 Eschenbach (DE)
(72) Erfinder: SCHULZ-HARDER, Jürgen, 91207 Lauf (DE); HABERL, Peter, 92242 Hirschau (DE)
(74) Vertreter: Graf, Helmut
(86) Internationale Anmeldenummer: PCT/DE2003/001242
(87) Internationale Veröffentlichungsnummer: WO 2004/002204

(56) Entgegenhaltungen:
- GB-A- 2 140 628
- US-A- 4 642 148
- US-A- 4 946 709
- US-B1- 6 207 221

## Beschreibung

Die Erfindung bezieht sich auf ein Metall-Keramik-Substrat gemäß Oberbegriff Patentanspruch 1, auf ein Verfahren zum Herstellen eines Metall-Keramik-Substrates gemäß Oberbegriff Patentanspruch 8 sowie auf ein Modul, insbesondere Halbleiterleistungsmodul mit einem Metall-Keramik-Substrat gemäß Oberbegriff Patentanspruch 12.

Metall-Keramik-Substrate, auch Kupfer-Keramik-Substrate für elektrische Schaltkreise, insbesondere für Halbleiter-Leistungs-Schaltkreise oder -module sind in verschiedensten Ausführungen bekannt. Bekannt ist es dabei speziell auch, die zum Herstellen von Leiterbahnen, Anschlüssen usw. benötigte Metallisierung auf einer Keramik, z.B. auf einer Aluminium-Oxid-Keramik mit Hilfe des sogenannten "DCB-Verfahrens" (Direct-Copper-Bond-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas , bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so daß durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Dieses DCB-Verfahren weist dann z.B. folgende Verfahrensschritte auf:
- Oxidieren einer Kupferfolie derart, daß sich eine gleichmäßige Kupferoxidschicht ergibt;
- Auflegen des Kupferfolie auf die Keramikschicht;
- Erhitzen des Verbundes auf eine Prozeßtemperatur zwischen etwa 1025 bis 1083°C, z.B. auf ca. 1071 °C;
- Abkühlen auf Raumtemperatur.

Die Herstellung von elektrischen Schaltkreisen oder Modulen, insbesondere die Fertigung von Leistungs-Schaltkreisen oder -modulen mit einem Leistungsteil und einem Ansteuer- oder Treiberteil erfolgt bisher so, daß als Substrat oder Leiterplatte für den Leistungsteil ein Metall-Keramik-Substrat verwendet wird und das der auf einer eigenständigen Leiterplatte mit seinen Bauelementen fertigbestückte Ansteuer- oder Treiberschaltkreis dann in einer weiteren Ebene über dem Leistungsteil oder aber neben diesem auf dem Metall-Keramik-Substrat mit geeigneten Mitteln montiert wird.

Nachteilig ist hierbei u.a. eine aufwendige Herstellung, da das Leistungsteil und die Ansteuer- oder Treiberstufe gesondert gefertigt und dann in der Fertigung zusammengeführt und miteinander verbunden werden müssen. Insbesondere ist mit dieser bekannten Technik eine den Gesichtspunkten einer rationellen Fertigung gerecht werdenden Herstellung des gesamten Moduls (Leistungsteil + Ansteuer- und Treiberstufe) im Mehrfachnutzen nicht möglich.

Aufgabe der Erfindung ist es, ein Metall-Keramik-Substrat aufzuzeigen, welches eine besonders rationale Fertigung von Schaltkreisen, insbesondere Halbleiterschaltkreisen und dabei speziell auch von Leistungsschaltkreisen mit zugehöriger Ansteuer- und Treiberstufe gestattet.

Zur Lösung dieser Aufgabe ist ein Metall-Keramik-Substrat entsprechend dem Patentanspruch 1 ausgebildet. Ein Verfahren zum Herstellen dieses Substrates ist entsprechend dem Patentanspruch 8 ausgebildet. Ein Halbleitermodul ist entsprechend dem Patentanspruch 12 ausgeführt.

Weiterbildungen der Erfindung sind Gegenstand der Unteransprüche.

Wesentliche Vorteile der Erfindung lassen sich, wie folgt, zusammenfassen:
- Vereinfachte Fertigung sowohl des Leitsungsbereichs, als auch des Ansteuer- und Treiberbereichs;
- genaue Positionierung des Leistungsbereichs und des Ansteuer- oder Treiberbereichs bzw. der dortigen, durch Strukturierung gebildeten Bereiche (Leiterbahnen, Kontaktflächen, Montageflächen usw.) und hierdurch auch Vereinfachung bei der Bestückung mit den Bauelementen;
- Bestückung des Leistungsbereichs und des Ansteuer- und Treiberbereichs in einem Arbeistsgang möglich;
- da keine organischen Substratmaterialen verwendet sind, sind hohe Löttemperaturen, beispielsweise Löttemperaturen bis zu 400°C beim Bestücken mit Bauelementen möglich, es können insbesondere auch bleifreie Lötmaterialien verwenden werden;
- ein Aufbringen einer Löt- oder Klebepaste beim Bestücken des Substrates ist wesentlich vereinfacht, da sich die Ebene der zu bestückenden Oberfläche des Leistungsteils und die Ebene der zu bestückenden Oberfläche des Ansteuer- oder Treiberteils im Niveau nur geringfügig unterscheiden;
- der Auftrag von Lötpasten oder Klebestoffen für die Bestücken sowohl des Leistungsteils als auch des Ansteuer- oder Treiberteils ist in einem Arbeitsgang mögl ich;
- vereinfachte Verdrahtung zwischen dem Leistungsteil und dem Ansteuer- und Treiberteil durch Ultraschall-Bonding;
- verbesserte Kühlung der Ansteuer- oder Treiberstufe durch verbesserte Anbindung an ein Kühlsystem;
- durch einfach realisierbare Cross-Over-Technik ist eine hohe Komplexität der Schaltung der Ansteuer- und Treiberstufe möglich.

Die Erfindung wird im folgenden anhand der Figuren an Ausführungsbeispielen näher erläutert. Es zeigen:
- Fig. 1 und 2: in vereinfachter Schnittdarstellung Halbleitermodule nach dem Stand der Technik;
- Fig. 3: in einer schematischen Schnittdarstellung den Schichtaufbau einer Ausführungsform des Metall-Keramik-Substrat gemäß der Erfindung;
- Fig. 4: in Schnittdarstellung ein Metall-Keramik-Substrat der Fig. 3 strukturiert mit einem Bereich zur Aufnahme von wenigstens einem Leistungs- Halbleiterbauelement und einem weiteren Bereich für einen Ansteuerschaltkreis;
- Fig. 5: und 6 jeweils in einer schematischen Schnittdarstellung den Schichtaufbau weiterer Ausführungsformen des Metall-Keramik-Substrat gemäß der Erfindung;
- Fig. 7: in Schnittdarstellung ein Halbleitermodul hergestellt unter Verwendung des strukturierten Metall-Keramik-Substrats der Fig. 4;
- Fig. 8: das Halbleitermodul der Figur 7, jedoch zusammen mit einer zusätzlichen Grundplatte;
- Fig. 9: in Teildarstellung und im Schnitt ein Halbleitermodul hergestellt unter Verwendung des strukturierten Metall-Keramik-Substrats der Fig. 5;
- Fig. 10: in vereinfachter Darstellung und in Draufsicht eine weitere mögliche Ausführungsform des erfindungsgemäßen Metall-Keramik-Substrates.

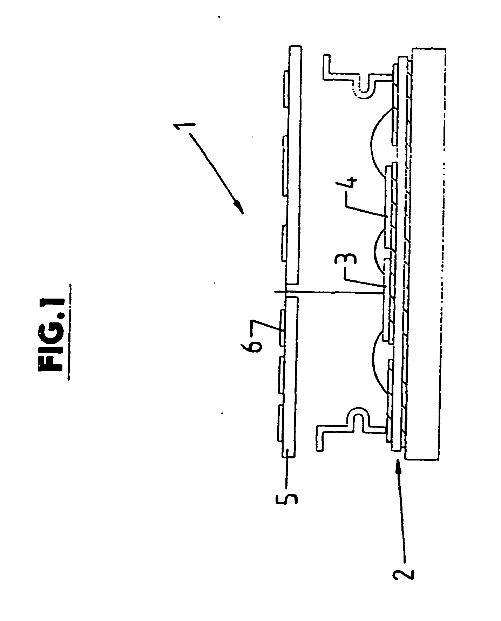

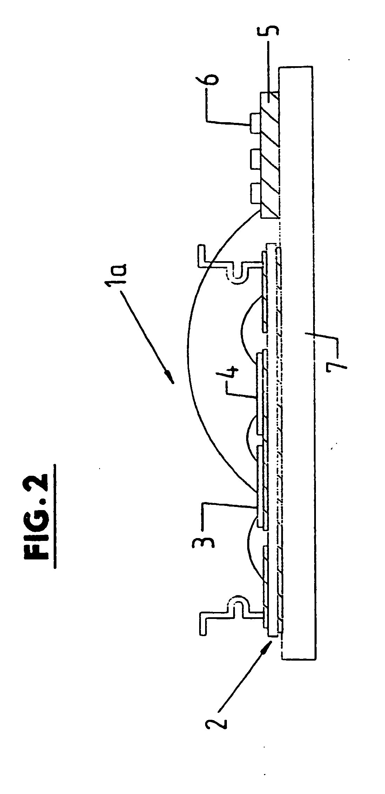

Die Figur 1 zeigt in vereinfachter Darstellung und im Schnitt ein Halbleitermodul 1, wie es aus dem Stand der Technik bekannt ist. Dieses Halbleitermodul besteht u.a. aus einem Kupfer-Keramik-Substrat 2 mit Halbleiter-Leistungsbauelementen 3 und 4, beispielsweise Transistoren oder Thyristoren zum Steuern eines elektrischen Antriebs usw., sowie aus einer Leiterplatine oder -platte 5 aus organischem Material (Kunststoff), die mit Bauelementen 6 bestückt ist und eine die Leistungsbauelemente 3 und 4 ansteuernde Treiberstufe- und/oder Regelstufe bildet. Die Leiterplatine oder -platte 5 mit den Bauelementen 6 ist oberhalb des Substrates 2 angeordnet. Die Figur 2 zeigt ein Halbleitermodul 1a, wie es ebenfalls aus dem Stand der Technik bekannt ist. Auf einer gemeinsamen Grundplatte 7 ist das Substrat 2 mit den Leistungsbauelementen 3 und 4 vorgesehen, und zwar zusammen mit der die Bauelemente 6 aufweisenden Leiterplatte 5 aus organischem Material (Kunststoff), die seitlich vom Substrat 2 auf einem Träger 7 angeordnet ist.

Der bekannte Aufbau hat den Nachteil einer aufwendigen Verdrahtung und sich hieraus ergebender hoher Montagekosten. Darüber hinaus ist es erforderlich, daß beide Teile des Moduls 1 bzw. 1a, nämlich das Substrat 2 und der die Leiterplatte 5 mit den Bauelementen 6 aufweisende Teil gesondert gefertigt, in der Fertigung zusammengeführt und mechanisch verbunden werden.

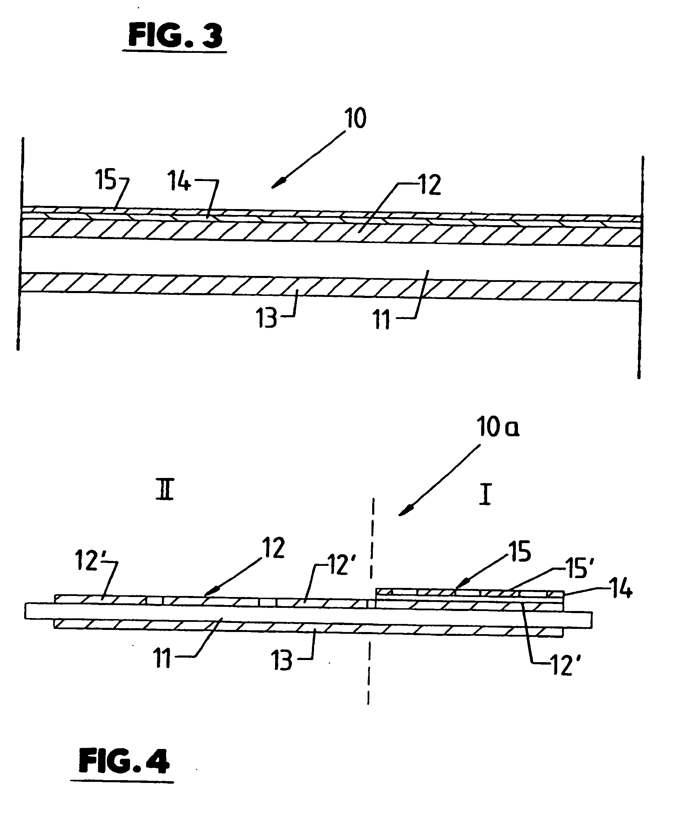

Die Figuren 3 zeigt den generellen Schichtaufbau eines Metall-Keramik-Substrates 10 gemäß der Erfindung. Dieses Substrat besteht aus der Keramikschicht 11, die beidseitig mit jeweils einer Metallschicht 12 bzw. 13 eines ersten Typs versehen ist. Bei der dargestellten Ausführungsform sind die Metallschichten 12 und 13 von Metallfolien gebildet, die mit Hilfe des Dired-Bonding-Verfahrens ganzflächig auf die Keramikschicht 11 aufgebracht sind.

Auf die in der Figur 3 obere Metallschicht 12 ist eine Schicht 14 aus einem Dielektrikum bzw. aus einem isolierenden Material aufgebracht, und zwar mit einer Dicke, die wesentlich kleiner ist als die Dicke der Metallschichten 12 und 13. Die Schicht 14 besteht beispielsweise aus einem glashaltigen Material, welches durch Erhitzen oder Einbrennen auf die Metallschicht 12 aufgebracht ist. Auf der isolierenden Schicht 14 ist eine weitere Metallschicht 15 eines zweiten Typs vorgesehen. Die Metallschicht 15 ist durch Aufbringen einer Leitpaste und durch Einbrennen dieser Leitpaste hergestellt, und zwar wiederum mit einer Dicke, die wesentlich kleiner ist als die Dicke der Metallschichten 12 und 13.

Die Dicke der Keramikschicht 11 beträgt beispielsweise 0,2 bis 2 mm. Die Metallschichten 12 und 13 besitzen beispielsweise eine Dicke im Bereich zwischen 0,1 bis 0,9 mm. Die Isolierschicht 14 besitzt eine Dicke im Bereich zwischen 0,015 bis 0,15 mm. Die Dicke der Metallschicht 15 liegt im Bereich zwischen etwa 0,015 bis 0,15 mm.

Bei der dargestellten Ausführungsform besitzen die Metallschichten 12 und 13 die selbe Dicke und bestehen aus Kupfer. Die Keramik der Keramikschicht 11 ist beispielsweise eine Aluminiumoxid-Keramik.

Die Herstellung des Mehrschicht-Metall-Keramik-Substrates erfolgt z.B. in einem Verfahren mit folgenden Verfahrensschritten:
a) Zur Bildung der Metallschichten 12 und 13 werden mittels des DCB-Prozesses wenigstens zwei an ihren Oberflächenseiten oxidierte Zuschnitte einer Kupferfolie jeweils auf eine Oberflächenseite der Keramikschicht 11 aufgebracht. Vor dem Aufbringen werden die Kupferfolienzuschnitte vorzugsweise in einem vorausgehenden Verfahrensschritt in einer Schutzgasatmosphäre, beispielsweise in einer Stickstoffatmosphäre getempert, und zwar zur Reduzierung der Härte des Kupfermaterials.
b) Nach dem Abkühlen wird auf die Metallschicht 12 beispielsweise durch Aufdrucken oder mit einem anderen, geeigneten Verfahren eine die spätere Isolierschicht 14 bildende Schicht aus einer glashaltigen Paste aufgebracht.
c) Die Paste wird getrocknet und dann bei einer Temperatur, die unter der Temperatur des DCB-Prozesses liegt, d.h. bei einer Temperatur im Bereich zwischen 750 und 1030°C eingebrannt, so daß die Paste dann die auf der Metallschicht 12 haftende Isolierschicht 14 bildet.
d) Nach einem erneuten Abkühlen wird auf die Isolierschicht 15, beispielsweise wiederum durch Aufdrucken oder mit einem anderen geeigneten Verfahren, eine metallische Bestandteile enthaltende Leitpaste aufgebracht,
e) die Leitpaste (Dickfilm) wird dann bei einer Temperatur im Bereich zwischen 750 bis 1030°C eingebrannt.

Um für die Isolierschicht 14 und/oder die Metallschicht 15 eine größere Dicke zu erreichen, können die Verfahrensschritte b) und c) und/oder d) und e) mehrfach wiederholt werden. Grundsätzlich besteht auch die Möglichkeit, auf die Metallschicht 15 noch wenigstens eine weitere Schichtfolge zumindest bestehend aus der Isolierschicht 14 und einer weiteren Metallschicht 15 aufzubringen. Das Oxidieren der Kupferfolienzuschnitte kann vor und/oder nach dem Tempern und auch während des DCB-Prozesses erfolgen.

Für die Isolierschicht 14 wird bevorzugt eine Paste verwendet, die nach dem Einbrennen eine Schicht 14 liefert, welche einen höheren Schmelzpunkt aufweist als die Paste vor dem Einbrennen, so daß ein mehrfaches Aufbringen und Einbrennen der glashaltigen Paste zur Erzielung einer größeren Schichtdicke möglich ist. Gleiches gilt auch für Paste, die für die Metallschicht 15 verwendet wird. Zum Herstellen der Isolierschicht 14 eignet sich beispielsweise eine von der Firma Du Pont Electronics unter der Bezeichnung "Dietectric Composition 4575D" angebotene Paste. Für die Herstellung der Metallschicht 15 eignet sich beispielsweise eine ebenfalls von der Firma Du Pont Electronics unter der Bezeichnung "Copper- Conductor Composition 9922" angebotene Paste.

Vorstehend wurde zur Erläuterung des generellen Schichtaufbaus sowie zur Erläuterung möglicher Herstellungsverfahren davon ausgegangen, daß die Schichtfolge bestehend aus der Isolierschicht 14 und der Metallschicht 15 die Metallschicht 12 auf ihrer gesamten Oberfläche überdeckt. In praktischen Anwendungen des erfindungsgemäßen Substrates erfolgt aber das Aufbringen der Schichtfolge(n) 14/15 in der Weise, daß diese Schichtfolge(n) nur einen Teil der Oberfläche der Metallschicht 12 einnimmt oder einnehmen, wie dies in der Figur 4 im dortigen Abschnitt I des dortigen Metall-Keramik-Substrat 10a angedeutet ist, während im Abschnitt II die Oberfläche der Metallschicht 12 frei liegt. Hierdurch besteht die Möglichkeit, die Metallschicht 12 mit geeigneten Technik, beispielsweise mit Ätz-MaskierungsTechniken zu strukturieren, und zwar zur Bildung von Leiterbahnen, Kontaktflächen usw., wie dies in der Figur 4 mit 12' angedeutet ist. In gleicher Weise ist auch die Metallschicht 15 zur Bildung von Leiterbahnen, Kontaktflächen, Anschlüssen usw. strukturiert, wie dies mit 15' angedeutet ist. Die Strukturierung der Metallschicht 15 ist dabei sehr viel feiner ausgeführt als die Strukturierung der Metallschicht 12, was allein schon wegen der wesentlichen geringeren Dicke der Metallschicht 15 möglich ist. Die Strukturierung der Metallschicht 15 erfolgt beispielsweise ebenfalls mit einer Ätz- und Maskierungstechnik und/oder aber dadurch, daß diese Strukturierung bereits durch entsprechendes strukturiertes Aufbringen der die Metallschicht 15 bildenden Leitpaste erreicht ist, beispielsweise durch strukturiertes Aufdrucken.

Wird die Metallschicht 15 mit einem Maskierungs-Ätz-Verfahren strukturiert, und zwar nach dem Strukturieren der Metallschicht 12, ist es grundsätzlich nicht erforderlich, die strukturierte Metallschicht 12 bzw. deren Bereiche 12' durch eine Maske aus Ätzresist abzudecken. Da die Schichtdicke der Metallschicht 15 sehr viel kleiner ist als die Schichtdicke der Metallschicht 12, hat beim Strukturieren der Metallschicht 15 ein zusätzliches Einwirken des Ätzmittels auf die Metallschicht 12 keine Wirkung. Allenfalls wird eine Abrundung von Kanten der strukturierten Bereiche 12' bewirkt und damit in vorteilhafter Weise durch das Vermeiden von scharfen Kanten die elektrische Spannungsfestigkeit erhöht.

Durch Verwendung der Direct-Bonding-Technik zum Aufbringen der Metallschichten 12 und 13 ist eine hohe Haftfestigkeit (Peelfestigkeit) größer als 30N/cm für diese Metallschichten an der Keramikschicht 11 erreicht. Diese hohe Haftfestigkeit ist wesentlich, um ein Abheben oder Lösen der Metallschicht 12 zu verhindern, insbesondere am Rand der Metallschicht 12 oder der strukturierten Bereiche 12', und zwar ein Abheben oder Lösen bedingt durch thermische Spannungen nach dem Abkühlen der Isolierschicht 14 und/oder der Metallschicht 15, jeweils nach dem Einbrennen.

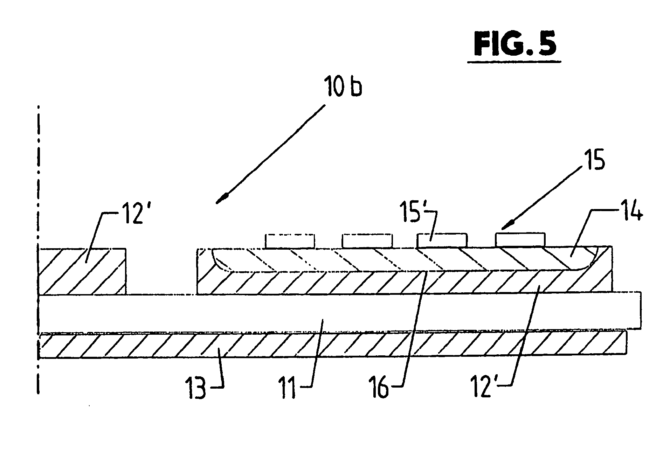

Die Figur 5 zeigt als weitere mögliche Ausführungsform ein Metall-Keramik-Substrat 10b, welches sich von dem Substrat 10a im wesentlichen nur dadurch unterscheidet, daß die Isolierschicht 14 in einer wannenartigen Vertiefung 16 eines strukturierten Bereichs 12' der Metallschicht 12 angeordnet ist. Abweichend von dem vorstehend beschriebenen Verfahren zum Herstellen des Metall-Keramik-Substrates 10 erfolgt die Herstellung des Substrates 10b beispielsweise so, daß nach dem Aufbringen der Metallschichten 12 und 13 mittels der Direct-Bondung-Techik (Verfahrensschritt a)) anschließend durch einen oder mehrere Verfahrensschritte, beispielsweise durch ein Maskierungs- und Ätzverfahren zunächst die muldenartige Vertiefung 16 in der Metallschicht 12 gebildet wird, und zwar ohne eine weitere Strukturierung der Metallschicht 12. Erst dann daran wird mit den weiteren Verfahrensschritten b) und c), die wiederum mehrfach ausgeführt werden können, die Isolierschicht 14 in der Vertiefung 16 gebildet und auf diese dann mit den Verfahrensschritten d) und e), die ebenfalls mehrfach ausgeführt werden können, die Metallschicht 15 aufgebracht. In weiteren Verfahrensschritten erfolgt dann zur Bildung der strukturierten Bereiche 12' und 15' die Strukturierung der Metallschichten 12 und 15, beispielsweise wiederum mit Ätz- und Maskierungstechniken. Ein strukturierter Bereich 12' weist dann die Vertiefung 16 mit der Isolierschicht 14 auf. Die übrigen strukturierten Bereiche 12' bilden z.B. Kontaktflächen, Leiterbahnen usw. für das oder die Halbleiter-Leistungsbauelemente bilden.

Die Metallschicht 15 ist bei der dargestellten Ausführungsform so strukturiert, daß sämtliche Bereiche 15' durch die Isolierschicht 14 von dem die Vertiefung 16 aufweisenden Bereich 12' elektrisch getrennt sind. Die Bereiche 15' bilden zumindest teilweise Leiterbahnen, Kontaktflächen usw. für die den Ansteuerschaltkreis mit geringerer Leistung.

Selbstverständlich sind zur Herstellung des Metall-Keramik-Substrates 10b auch andere Verfahren denkbar, z.B. solche, bei denen bereits beim Einbringen der Vertiefung 16 oder aber in einem vorausgehenden oder anschließenden Verfahrensschritt die Strukturierung der Metallschicht 12 zur Bildung der Bereiche 12' erfolgt und/oder die strukturierten Bereiche 15' der Metallschicht wiederum durch strukturiertes Aufbringen der diese Metallschicht bildenden Paste erfolgt.

Das Metall-Keramik-Substrat 10b mit der Vertiefung 16 hat den Vorteil, daß das Aufbringen der Isolierschicht 14 vereinfacht ist und darüber hinaus die Oberseite dieser Isolierschicht in einer Ebene mit der Oberseite der Metallschicht 12 bzw. der Bereiche 12' liegt, was für das Herstellungsverfahren, insbesondere auch für die weitere Verarbeitung dieses Substrates von besonderem Vorteil sein kann.

Weiterhin ist es durch die Ausbildung möglich, die Isolierschicht 14 so aufzubringen, daß die Oberseite des für die Vertiefung 16 aufweisenden Bereichs 12' von dem die Isolierschicht 14 bildenden Material zuverlässig frei gehalten ist, so daß sich außerhalb der Isolierschicht 14 an der Oberseite des die Vertiefung 16 aufweisenden Bereichs 12' eine reine metallische Fläche ergibt, auf der weitere Elemente, beispielsweise auch ein Gehäuse, z.B. durch Löten oder auf andere Weise hermetisch dicht befestigt werden kann, und zwar ohne Störungen durch Reste des die Isolierschicht 14 bildenden Materials.

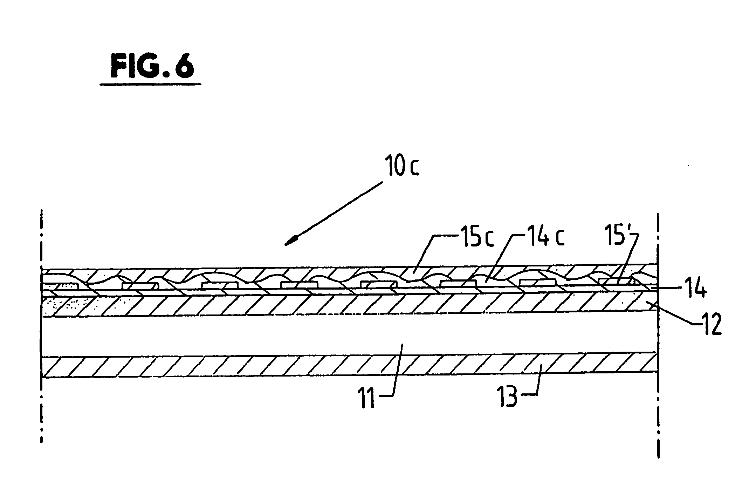

Die Figur 6 zeigt im Teilschnitt als weitere mögliche Ausführung den Schichtaufbau eines Metall-Keramik-Substrates 10c, welches sich von dem Substrat 10 dadurch unterscheidet, daß nach dem Strukturieren der Metallschicht 15 auf diese bzw. auf deren strukturierte Bereiche 15' eine weitere Isolierschicht 14 aufgebracht wird, und zwar wiederum durch Auftragen und durch Einbrennen der glashaltigen Paste nach dem Trocknen.

Beim Aufbringen der weiteren Isolierschicht 14c werden in dieser Öffnungen oder Fenster vorgesehen, und zwar über einigen der strukturierten Bereiche 15', so daß dann beim Aufbringen der weiteren Metallschicht 15c, die der Metallschicht 15 entspricht und die wiederum durch Auftragen und Einbrennen der Leitpaste erzeugt wird, eine elektrische Verbindung zwischen den strukturierten Bereichen 15' und der weiteren, darüberliegenden Metallschicht 15c bestehen. Hierbei ist es selbstverständlich auch möglich, auf der Metallschicht 15c, vorzugsweise nach der Strukturierung dieser Metallschicht weitere Schichtfolgen bestehend aus wenigstens einer Isolierschicht entsprechend der Isolierschicht 14 oder 14c und wenigstens einer Metallschicht entsprechend der Metallschicht 15 bzw. 15c aufzubringen. Mit dem in der Figur 6 dargestellten Aufbau sind somit sehr komplexe Metall-Keramik-Substrate oder Substratbereiche für Schaltkreise mit reduzierter Leistung, insbesondere auch für Ansteuer- und Regelschaltkreise für elektrische Leistungsbauelemente realisierbar, und zwar bei kleinem Bauvolumen.

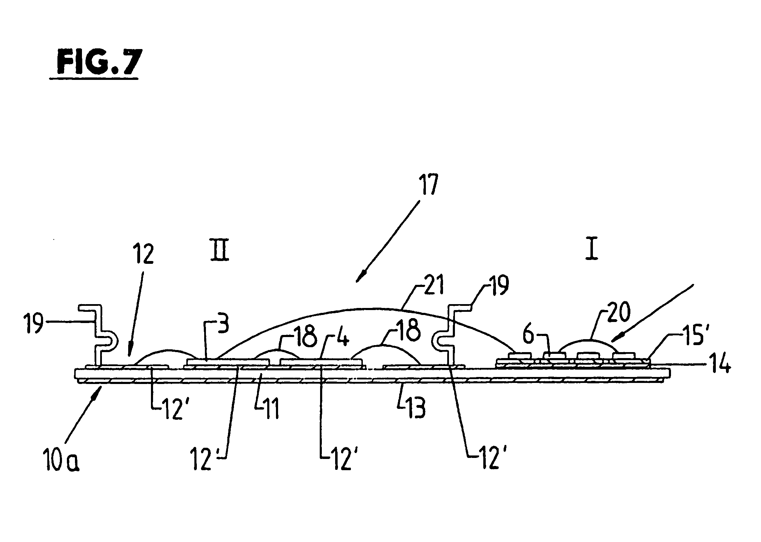

Die Figur 7 zeigt in vereinfachter Darstellung und im Schnitt ein Halbleiterleistungsmodul 17, welches unter Verwendung des Metall-Keramik-Substrates 10a hergestellt ist. Auf dem Abschnitt 11 des Substrates 10a bzw. auf zwei dortigen, strukturierten Bereichen 12' ist jeweils ein Halbleiterleistungsbauelement 3 bzw. 4 vorgesehen. Über interne elektrische Verbindungen 18 (z.B. Drahtbonds) sind die Bauelemente 3 und 4 u.a. mit weiteren Bereichen 12' verbunden, die als Kontaktflächen dienen und an denen äußere Leistungsanschlüsse 19 vorgesehen ist.

Die strukturierten Bereiche 15' bilden die Leiterbahnen, Kontaktflächen usw. für den Ansteuerschaltkreis oder Treiber zum Ansteuern der die Bauelemente 3 und 4 aufweisenden Leistungsstufe. Auf den Bereichen 15' sind die entsprechenden Bauelemente 6 dieser Treiberstufe vorgesehen. Weitere Bereiche 15' bilden Kontaktflächen, die über interne Anschlüsse 20 mit den Bauelementen, Leiterbahnen usw. verbunden sind und die dann beispielsweise auch äußere Steueranschlüsse des Moduls 17 bilden, sowie auch Kontaktflächen, die über interne Verbindungen 21 mit dem Leistungsteil II verbunden sind.

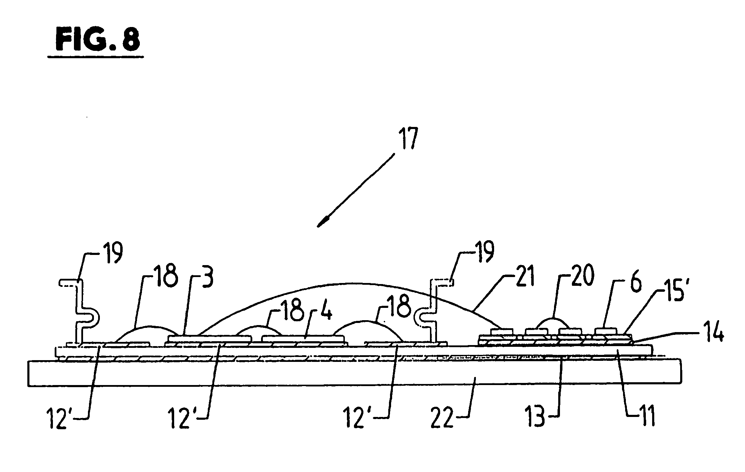

Die Figur 8 zeigt nochmals das Leistungsmoduf 17, zusammen mit einer Grundplatte 22 aus einem Material, welches eine hohe Wärmeleitfähigkeit sowie hohe mechanische Stabilität aufweist. Insbesondere bei großen, komplexen Modulen ist diese Grundplatte 22 zur Erhöhung der mechanischen und/oder thermischen Stabilität, auch zur Vermeidung von Verformungen des Metall-Keramik-Substrates 10a bei Temperaturschwankungen usw. zweckmäßig.

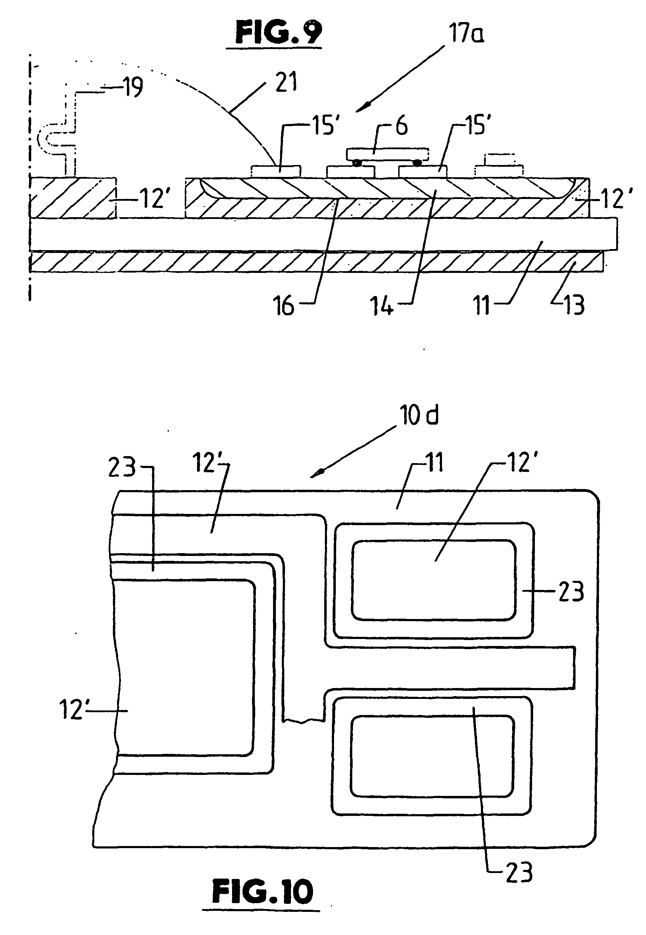

Anstelle des Substrates 10a kann bei einem Leistungsmodul selbstverständlich auch ein anderes Metall-Keramik-Substrat gemäß der Erfindung verwendet werden, beispielsweise das Substrat 10b oder 10c, d.h. ein Substrat mit dem in den Figuren 5 und 6 dargestellten Aufbau. Die Figur 9 zeigt ein Modul 1 7a mit dem Substrat 10b.

Als Metall für die Metallschichten, insbesondere auch für die Metallschichten 12 und 13 eignet sich Kupfer, wobei dann die Metallschichten 12 und 13 unter Verwendung von Kupferfolien und unter Anwendung der DCB-Technik (Direct-Copper-Bonding Technik) hergestellt werden. Die Verwendung auch anderer Metalle ist grundsätzlich möglich.

Als Keramik eignet sich für die Keramikschicht 11 beispielsweise eine Aluminiumoxid-Keramik (Al₂O₃). Grundsätzlich sind auch andere Keramiken denkbar, beispielsweise AlN, BeO, CBN, Si₃N₄ und SiC.

Bei dem vorstehend in Zusammenhang mit der Figur 3 beschriebenen Verfahren wurde davon ausgegangen, daß die die Metallschicht bildende Metall- oder Leitpaste (Dickfilmpaste) entweder unstrukturiert aufgebracht und eingebrannt wird, worauf dann anschließend eine Strukturierung zur Erzeugung der Bereiche 15' durch eine geeignete Technik, beispielsweise durch eine Maskierungs- und Ätztechnik erfolgt, oder aber daß die Leitpaste bereits in der gewünschten Strukturierung aufgebracht und eingebrannt wird. Es besteht weiterhin die auch Möglichkeit, daß eine fotoempfindliche Leitpaste verwendet wird, d.h. eine Leitpaste, die nach dem Aufbringen und vor dem Einbrennen entsprechend der gewünschten Struktur belichtet wird, wobei dann z.B. die nicht belichteten Bereich beispielsweise in einem anschließenden Verfahrensschritt ("Entwicktungsverfahrens") entfernt werden, so daß eine sehr feine Strukturierung vor dem Einbrennen der Leitpaste erreicht ist. Die fotoempfindliche Leitpaste kann auch so ausgebildet sein, daß nach dem Belichten die belichteten Bereiche entfernt werden können.

Ein Verfahren zum Herstellen des Metall-Keramik-Substrates hätte dann bei Verwendung der fotoempfindliche Leitpaste die nachstehend aufgeführten Verfahrensschritte:
a) Zur Bildung der Metallschichten 12 und 13 werden mittels des DCB-Prozesses wenigstens zwei an ihren Oberflächenseiten oxidierte Zuschnitte einer Kupferfolie jeweils auf eine Oberflächenseite der Keramikschicht 11 aufgebracht. Vor dem Aufbringen werden die Kupferfolienzuschnitte vorzugsweise in einem vorausgehenden Verfahrensschritt in einer Schutzgasatmosphäre, beispielsweise in einer Stickstoffatmosphäre getempert, und zwar zur Reduzierung der Härte des Kupfermaterials.
b) Nach dem Abkühlen wird auf die Metallschicht 12 beispielsweise durch Aufdrucken oder mit einem anderen, geeigneten Verfahren eine die spätere Isolierschicht 14 bildende Schicht aus einer glashaltigen Paste aufgebracht.
c) Die Paste wird getrocknet und dann bei einer Temperatur, die unter der Temperatur des DCB-Prozesses liegt, d.h. beispielsweise bei einer Temperatur im Bereich zwischen 750 und 1030°C eingebrannt, so daß die Paste dann die auf der Metallschicht 12 haftende Isolierschicht 14 bildet.
d1) Anschließend wird eine Schicht aus der fotoempfindlichen Leitpaste aufgetragen und diese Schicht entsprechend der gewünschten Strukturierung belichtet.
d2) In einem anschließenden Verfahrensschritt werden die belichteten oder nicht belichteten Bereiche der von der Paste gebildeten Schicht entfernt.
e) Die strukturierte Leitpaste (Dickfilm) wird dann bei einer Temperatur im Bereich zwischen 750 bis 1030°C eingebrannt.

Das Strukturieren der Metallschicht 12 erfolgt bei diesem Verfahren beispielsweise vor dem Aufbringen der Isolierschicht 14, d.h. anschließend an den obigen Verfahrensschritt a).

Die Figure 10 zeigt in vereinfachter Teildarstellung und in Draufsicht ein Metall-Keramik-Substrat 10d mit den von der Metallschicht 12 gebildeten strukturierten Bereichen 12'. Einige Bereiche 12' sind bei der dargestellten Ausführungsform jeweils an ihrem Rand mit einem rahmenartigen Lotstoppauftrag 23 versehen, der von einer auf die frei liegende Oberseite der Bereiche 12' aufgebrachten Schicht aus der glashaltigen Paste, z.B. "Dielectric Composition 4575D" gebildet ist, die vorstehend für die Isolierschicht 14 verwendet wurde. Es hat sich gezeigt, daß durch diesen Auftrag 23 ein optimal wirkender Lotstop erreicht wird, d.h. es ist wirksam verhindert, daß bei Auflöten von Bauelementen, Anschlüssen usw. auf die mit dem Lotstopauftrag 23 versehenen Bereiche Lot über diesen Lotstop an angrenzende Bereiche 12' fließt und dadurch unerwünschte elektrische Verbindungen erzeugt. Jeder Lotstopauftrag 23 umschließt dabei denjenigen Teil des strukturierten Bereichs 12', auf den (Teil) später Lot aufgebracht wird. Durch das verwendete Material (glashaltige Paste) besitzt der jeweilige Lotstopauftrag 23 eine hohe Temperaturfestigkeit, was wiederum dazu beiträgt, daß Lotmaterialien mit hoher Verarbeitungstempertur verwendet werden können, insbesondere auch bleifreie Lotmaterialien.

Die Herstellung des Substrates 10d erfolgt in der Weise, daß nach dem Aufbringen der Metallschicht 12 und ggfs. auch der Metallschicht 13 (sofern vorhanden) auf die Keramikschicht 11 mittels der Direct-Bonding-Technik und nach dem Strukturieren der Metallschicht 12 der Auftrag der glashaltigen Paste entsprechend dem gewünschten Verlauf des jeweiligen Lotstopauftrags 23 auf Bereiche 12' erfolgt, und zwar mit einer Dicke von etwa 0,015 - 0,15 mm. Nach dem Trockenen der Paste wird diese bei einer Temperatur zwischen 750 und 1030°C eingebrannt.

Wird auf dem Substrat 10d wenigstens eine Isolierschicht 14 aufgebracht, so erfolgt das Aufbringen, Trocknen und Einbrennen der glashaltigen Paste für die Isolierschicht 14 und den jeweiligen Lotstopauhrag 23 in gemeinsamen Arbeitsschritten.

Die Erfindung wurde voranstehend an Ausführungsbeispielen beschrieben. Es versteht sich, daß zahlreiche Änderungen sowie Abwandlungen möglich sind.

## Patentansprüche

1. Metall-Keramik-Substrat für elektrische Schaltkreise oder Module, insbesondere für solche mit wenigstens einem Leistungsteil (II) und mit wenigstens einem Schaltungsteil geringerer Leistung, mit wenigstens einer Keramikschicht mit einer Dicke im Bereich zwischen 0,2 - 2 mm, mit wenigstens einer auf einer Oberflächenseite der Keramikschicht flächig aufgebrachten Metallschicht (12, 13) eines ersten Typs und mit einer Dicke im Bereich zwischen 0,1 und 0,9 mm, wobei die wenigstens eine Metallschicht (12) des ersten Typs oder strukturierte Bereiche (12') dieser Metallschicht zumindest einen Leistungsbereich zur Anordnung von Leistungsbauelementen (4,5) bildet,
**dadurch gekennzeichnet,**
**dass** auf wenigstens einen Teilbereich oder strukturierten Bereich der der Keramikschicht (11) abgewandten Oberflächenseite der wenigstens einen Metallschicht (12) des ersten Typs eine Isolierschicht (14) aus einem glashaltigen Material mit einer Dicke von etwa 0,015 - 0,15 mm aufgebracht ist, und
**dass** auf diese Isolierschicht unter Verwendung einer Leitpaste und mit einer Dicke zwischen 0,015 - 0,15 mm wenigstens eine strukturierte Metallschicht (15) eines zweiten Typs aufgebracht ist, die wenigstens einen Ansteuer- oder Regelbereich des Substrates bildet.

2. Substrat nach Anspruch 1, **dadurch gekennzeichnet, dass** zumindest auf einem Teilbereich der wenigstens eine Metallisierung (12) des ersten Typs mehrere Schichtfolgen bestehend aus der Isolierschicht (14, 14c) und der Metallschicht (15, 15c) des zweiten Typs vorgesehen sind.

3. Substrat nach Anspruch 1 oder 2, **dadurch gekennzeichnet, dass** die Isolierschicht (14) in einer Vertiefung (16) einer darunterliegenden Schicht, beispielsweise in einer Vertiefung (16) der einen Metallschicht (12) des ersten Typs vorgesehen ist,
wobei die Vertiefung beispielsweise eine Tiefe im Bereich zwischen etwa 0,015
und 0,15 mm aufweist.

4. Substrat nach einem der vorhergehenden Ansprüche, **dadurch gekennzeichnet, dass** auf beiden Oberflächenseiten der wenigstens einen Keramikschicht (11) jeweils eine Metallschicht (12, 13) des ersten Typs aufgebracht ist,
wobei beispielsweise nur auf einer der beiden Metallschichten des ersten Typs die wenigstens eine Isolierschicht (14) mit der weiteren Metallschicht (15) des zweiten Typs und/oder die von mehreren Isolierschichten (14, 14c) und/oder mehreren Metallschichten (15, 15') des zweiten Typs gebildete Schichtfolge versehen ist.

5. Substrat nach einem der vorhergehenden Ansprüche, **dadurch gekennzeichnet, dass** die wenigstens eine Metallschicht (12, 13) des ersten Typs auf die Keramikschicht mit einer Peelfestigkeit größer 30Ncm angebracht ist,
und/oder
dass der thermische Ausdehnungskoeffizient der wenigstens einen Metallschicht (12, 13) des ersten Typs in der Ebene des Substrats, d.h. parallel zur Substratoberseite kleiner als 10ppm ist;
und/oder
dass das Metall der wenigstens einen Metallschicht des ersten Typs Kupfer ist, und/oder
dass die wenigstens eine Metallschicht (12, 13) des ersten Typs von einer Metallfolie, beispielsweise Kupferfolie gebildet ist, die mittels der Direct-Bonding-Technik auf der Keramikschicht befestigt ist.

6. Substrat nach einem der vorhergehenden Ansprüche, **dadurch gekennzeichnet, dass** die wenigstens eine weitere Metallschicht (15, 15c) des zweiten Typs unter Verwendung einer metallische Bestandteile aufweisenden Paste erzeugt ist.

7. Substrat nach einem der vorhergehenden Ansprüche, **dadurch gekennzeichnet, dass** wenigstens ein strukturierter Bereich (12'), vorzugsweise ein strukturierter Bereich der wenigstens einen Metallschicht des ersten Typs mit einem Lotstopauftrag versehen ist, der aus einem glashaltigen Material besteht,
wobei der Lotstopauhrag (23) beispielsweise durch Auftragen und Einbrennen einer glashaltigen Paste erzeugt ist.

8. Verfahren zum Herstellen eines Metall-Keramik-Substrats, bei dem auf wenigstens einer Oberflächenseite einer Keramikschicht mit Hilfe des Direct-Bonding-Verfahrens eine Metallfolie, beispielsweise einer Kupferfolie, zur Bildung einer Metallschicht eines ersten Typs zur Bildung von Kontaktflächen, Montageflächen und/oder Leiterbahnen für wenigstens einen Leistungsbereich des Substrats befestigt wird, **dadurch gekennzeichnet, dass** auf der Metallschicht (12) des ersten Typs im wenigstens einem Teilbereich
zur Bildung einer Isolierschicht eine glashaltige Paste aufgebracht, anschließend getrocknet und bei einer Temperatur im Bereich zwischen 750 und 1030°C eingebrannt wird, und daß auf der Isolierschicht (14, 14c) durch Auftragen und Einbrennen einer metallische Bestandteile aufweisenden Paste (Leitpaste) bei einer Temperatur im Bereich zwischen 750 und 1030°C eine weitere Metallschicht (15, 15c) eines zweiten Typs erzeugt wird, die zur Bildung von Leiterbahnen, Kontaktflächen, Montageflächen für wenigstens einen Ansteuer- oder Treiberbereich strukturiert werden kann.

9. Verfahren nach Anspruch 8, **dadurch gekennzeichnet,**
**dass** die zur Bildung der wenigstens einen Metallschicht (12, 13) des ersten Typs verwendete Metallfolie vor dem Verbinden mit der Keramikschicht (11) in einer inerten Atmosphäre, beispielsweise Stickstoffatmosphäre durch Erhitzen bei einer Temperatur getempert wird, die (Temperatur) unter der Prozeßtemperatur des Dired-Bonding-Verfahrens liegt,
und/oder
**dass** zur Erhöhung der Dicke der wenigstens einen Isolierschicht aus dem glashaltigen Material das Auftragen der glashaltigen Paste und das Einbrennen dieser Paste wenigstens einmal wiederholt wird;
und/oder
**dass** zur Erhöhung der Dicke der weiteren Metallschicht des zweiten Typs (15, 15c) das Auftagen und Einbrennen der diese Metallschicht bildenden Paste wenigstens einmal wiederholt wird.

10. Verfahren nach einem der Ansprüche 8 oder 9, **dadurch gekennzeichnet, dass** auf
die wenigstens eine Metallschicht (12) des ersten Typs zumindest in einem Teilbereich eine Schichtfolge aufgebracht wird, die wenigstens zwei Isolierschichten 814) aus dem glashaltigen Material und/oder wenigstens zwei Metallschichten (15, 15c) des zweiten Typs aufweisen.

11. Verfahren nach einem der Ansprüche 8 bis 10, **dadurch gekennzeichnet, dass**
mehrere Substrate im Mehrfachnutzen auf einer gemeinsamen, die Keramikschicht (11) bildenden Keramikplatte hergestellt werden,
und/oder
dass auf einen Teilbereich der Metallschicht (12), vorzugsweise auf wenigstens einen strukturierten Bereich (12') dieser Metallschicht durch Auftragen und Einbrennen der glashaltigen Paste ein Lotstopauftrag oder -bereich (23) gebildet wird, wobei das Aufbringen des Lotstopbereichs beispielsweise zusammen mit dem Aufbringen der Isolierschicht (14, 14c) erfolgt.

12. Modul, hergestellt unter Verwendung eines Metall-Keramik-Substrates nach einem
der Ansprüche 1 - 9, **dadurch gekennzeichnet, dass** wenigstens ein frei liegender, strukturierter Bereich (II) der Metallschicht des ersten Typs Leiterbahnen, Kontaktflächen, Montageflächen usw. für wenigstens ein dort vorgesehenes Halbleiterbauelement (3, 4) bildet und dass die wenigstens eine Metallschicht (15, 15c) mit strukturierten Bereichen (15') Leiterbahnen, Kontaktflächen und/oder Montageflächen für zumindest ein Bauelement (6) wenigstens einer Treiber- oder Ansteuerstufe bildet.

## Claims

1. Metal-ceramic substrate for electrical circuits or modules, more particularly for those having at least one power element (II) and at least one circuit part of lower output, with at least one ceramic layer with a thickness in the range from between 0.2 and 2 mm, with at least one metal layer (12, 13) of a first type and applied with a thickness in the range from between 0.1 and 0.9 mm flat over one surface side of the ceramic layer, wherein the at least one metal layer (12) of the first type or structured areas (12') of this metal layer forms at least one power range for mounting power components (4, 5)
**characterised in that**
an insulation layer (14) of a glass-containing material is applied with a thickness of about 0.015-0.15 mm to at least one partial area or structured area of the surface side of the at least one metal layer (12) of the first type remote from the ceramic layer (11), and that at least one structured metal layer (15) of a second type is applied to this insulation layer by using a conductive paste and to a thickness of between 0.015-0.15 mm to form at least one activating or control area of the substrate.

2. Substrate according to claim 1 **characterised in that** several stratifications consisting of the insulation layer (14, 14c) and the metal layer (15, 15c) of the second type are provided at least on one partial area of the at least one metal plating (12) of the first type.

3. Substrate according to claim 1 or 2 **characterised in that** the insulation layer (14) is provided in an indentation (16) of a layer underneath, by way of example in an indentation (16) of the one metal layer (12) of the first type, wherein the indentation has by way of example a depth in the range of between about 0.015 and 0.15 mm.

4. Substrate according to one of the preceding claims **characterised in that** a metal layer (12, 13) of the first type is applied to each surface of the at least one ceramic layer (11),
wherein the at least one insulation layer (14) with the further metal layer (15) of the second type and/or the stratification formed by the several insulation layers (14, 14c) and/or several metal layers (15, 15') of the second type is provided by way of example only on one of the two metal layers of the first type.

5. Substrate according to one of the preceding claims **characterised in that** the at least one metal layer (12, 13) of the first type is applied to the ceramic layer with a peel strength of greater than 30 Ncm,
and/or
that the coefficient of thermal expansion of the at least one metal layer (12, 13) of the first type in the plane of the substrate, i.e. parallel to the top side of the substrate is less than 10 ppm;
and/or
that the metal of the at least one metal layer of the first type is copper,
and/or that the at least one metal layer (12, 13) of the first type is formed by a metal foil, by way of example copper foil, which is fixed to the ceramic layer by means of the direct bonding technology.

6. Substrate according to one of the preceding claims **characterised in that** the at least one further metal layer (15, 15c) of the second type is created by the use of a conductive paste containing metallic constituents.

7. Substrate according to one of the preceding claims **characterised in that** at least one structured region (12'), preferably a structured region of the at least one metal layer of the first type is provided with a solder stop barrier which consists of a glass-containing material wherein the solder stop barrier (23) is produced by way of example by applying and firing a glass-containing paste.

8. Method for manufacturing a metal ceramic substrate in which a metal foil, by way of example a copper foil, is fixed on at least one surface side of a ceramic layer by means of the direct bonding process, to form a metal layer of a first type to form contact surfaces, mounting surfaces and/or conductor paths for at least one power region of the substrate, **characterised in that** a glass-containing paste is applied to the metal layer (12) of the first type in at least one partial region to form an insulation layer, where it is then dried and fired at a temperature in the range between 750° and 1030° C, and that a further metal layer (15, 15c) of a second type is produced on the insulation layer (14, 14c) by applying and firing a paste (conductive paste) comprising metal constituents at a temperature in the range from between 750° and 1030°C wherein this further metal layer can be structured to form conductor paths, contact surfaces, mounting surfaces for at least one activating or driver region.

9. Method according to claim 8 **characterised in that**
the metal foil used to form the at least one metal layer (12, 13) of the first type is tempered prior to bonding with the ceramic layer (11) in an inert atmosphere, by way of example nitrogen atmosphere, by heating at a temperature which lies below the process temperature of the direct bonding process,
and/or
that in order to increase the thickness of the at least one insulation layer of glass-containing material the application of the glass-containing paste and the firing of this paste is repeated at least once;
and/or
that in order to increase the thickness of the further metal layer of the second type (15, 15c) the application and firing of the paste forming this metal layer is repeated at least once

10. Method according to one of claims 8 or 9 **characterised in that** a stratification comprising at least two insulation layers (814) of the glass-containing material and/or at least two metal layers (15, 15c) of the second type, is applied to the at least one metal layer (12) of the first type at least in one partial region.

11. Method according to one of claims 8 to 10 **characterised in that** several substrates are produced in multiple printed panels on a common ceramic paste forming the ceramic layer (11)
and/or
that a solder stop barrier or region (23) is formed on a partial region of the metal layer (12), preferably on at least one structured region (12') of this metal layer by applying and firing the glass-containing paste wherein the application of the solder stop region is carried out by way of example at the same time as the application of the insulation layer (14, 14c).

12. Module, manufactured by using a metal ceramic substrate according to one of claims 1 to 9 **characterised in that** at least one freely exposed structured region (II) of the metal layer of the first type forms conductor paths, contact surfaces, mounting surfaces etc for at least one semi conductor element (3, 4) provided there, and that the at least one metal layer (15, 15c) with structured regions (15') forms conductor paths, contact surfaces and./or mounting surfaces for at least one component part (6) of at least one driver or activating phase.

## Revendications

1. Substrat métal-céramique pour circuits de commutation ou modules électriques, en particulier pour ceux comportant au moins un élément de puissance (II) et au moins un élément de commutation de puissance inférieure, avec au moins une couche céramique d'une épaisseur comprise entre 0,2 et 2 mm, avec au moins une couche métallique (12, 13) d'un premier type appliquée en nappe sur un côté de la surface de la couche céramique et d'une épaisseur comprise entre 0,1 et 0,9 mm, l'au moins une couche métallique (12) du premier type ou des zones structurées (12') de cette couche métallique formant au moins une zone de puissance pour l'agencement de composants de puissance (4, 5),
**caractérisé**
**en ce qu'**une couche isolante (14) en un matériau contenant du verre d'une épaisseur d'environ 0,015 - 0,15 mm est appliquée sur au moins une partie ou une zone structurée du côté de la surface, opposé à la couche céramique (11), de l'au moins une couche métallique (12) du premier type, et
**en ce qu'**au moins une couche métallique structurée (15) d'un deuxième type, qui forme au moins une zone de commande ou de réglage du substrat, est appliquée sur cette couche isolante en utilisant une pâte conductrice et d'une épaisseur comprise entre 0,015 et 0,15 mm.

2. Substrat selon la revendication 1, **caractérisé en ce que** plusieurs successions de couches constituées de la couche isolante (14, 14c) et de la couche métallique (15, 15c) du deuxième type sont prévues au moins sur une partie de l'au moins une métallisation (12) du premier type.

3. Substrat selon la revendication 1 ou 2, **caractérisé en ce que** la couche isolante (14) est prévue dans un évidement (16) d'une couche sous-jacente, par exemple dans un évidement (16) d'une couche métallique (12) du premier type, l'évidement ayant par exemple une profondeur comprise entre environ 0,015 et 0,15 mm.

4. Substrat selon l'une quelconque des revendications précédentes, **caractérisé en ce que** respectivement une couche métallique (12, 13) du premier type est appliquée sur les deux côtés de la surface de l'au moins une couche céramique (11),
dans lequel l'au moins une couche isolante (14) avec l'autre couche métallique (15) du deuxième type et/ou la succession de couches formée de plusieurs couches isolantes (14, 14c) et/ou plusieurs couches métalliques (15, 15') du deuxième type est pourvue par exemple uniquement sur l'une des deux couches métalliques du premier type.

5. Substrat selon l'une quelconque des revendications précédentes, **caractérisé en ce que** l'au moins une couche métallique (12, 13) du premier type est appliquée sur la couche céramique avec une résistance au pelage supérieure à 30 Ncm,
et/ou
**en ce que** le coefficient de dilatation thermique de l'au moins une couche métallique (12, 13) du premier type dans le plan du substrat, autrement dit, parallèlement à la face supérieure du substrat est inférieure à 10 ppm ;
et/ou
**en ce que** le métal de l'au moins une couche métallique du premier type est du cuivre,
et/ou
**en ce que** l'au moins une couche métallique (12, 13) du premier type est formée d'une feuille métallique, par exemple d'une feuille de cuivre, qui est fixée sur la couche céramique au moyen de la technique de liaison directe.

6. Substrat selon l'une quelconque des revendications précédentes, **caractérisé en ce que** l'au moins une autre couche métallique (15, 15c) du deuxième type est produite en utilisant une pâte présentant des composants métalliques.

7. Substrat selon l'une quelconque des revendications précédentes, **caractérisé en ce qu'**au moins une zone structurée (12'), de préférence une zone structurée de l'au moins une couche métallique du premier type, est pourvue d'une couche d'arrêt de soudure qui se compose d'un matériau contenant du verre,
dans lequel la couche d'arrêt de soudure (23) est obtenue par exemple par application et cuisson d'une pâte contenant du verre.

8. Procédé de production d'un substrat métal-céramique, dans lequel une feuille métallique, par exemple une feuille de cuivre, pour former une couche métallique d'un premier type pour former des surfaces de contact, surfaces de montage et/ou pistes conductrices pour au moins une zone de puissance du substrat est fixée sur au moins un côté de la surface d'une couche céramique à l'aide du procédé de liaison directe, **caractérisé en ce qu'**une pâte contenant du verre est appliquée sur la couche métallique (12) du premier type dans au moins une partie pour former une couche isolante, puis séchée et cuite à une température comprise entre 750 et 1030°C, et **en ce qu'**une autre couche métallique (15, 15c) d'un deuxième type, qui peut être structurée pour former des pistes conductrices, surfaces de contact, surfaces de montage pour au moins une zone de commande ou d'excitation, est produite sur la couche isolante (14, 14c) par application et cuisson d'une pâte présentant des composants métalliques (pâte conductrice) à une température comprise entre 750 et 1030°C.

9. Procédé selon la revendication 8, **caractérisé**
**en ce que** la feuille métallique utilisée pour former l'au moins une couche métallique (12, 13) du premier type est amenée avant la liaison avec la couche céramique (11) dans une atmosphère inerte, par exemple une atmosphère d'azote, par échauffement à une température qui est inférieure à la température du procédé de liaison directe,
et/ou
**en ce que** pour augmenter l'épaisseur de l'au moins une couche isolante en matériau contenant du verre, l'application de la pâte contenant du verre et la cuisson de cette pâte sont répétées au moins une fois ;
et/ou
**en ce que** pour augmenter l'épaisseur de l'autre couche métallique du deuxième type (15, 15c), l'application et la cuisson de la pâte formant cette couche métallique sont répétées au moins une fois.

10. Procédé selon l'une quelconque des revendications 8 ou 9, **caractérisé en ce qu'**une succession de couches, qui présente au moins deux couches isolantes (14) en matériau contenant du verre et/ou au moins deux couches métalliques (15, 15c) du deuxième type, est appliquée sur l'au moins une couche métallique (12) du premier type au moins dans une partie.

11. Procédé selon l'une quelconque des revendications 8 à 10, **caractérisé en ce que** plusieurs substrats sont produits dans le flan imprimé multiple sur une plaque céramique commune formant la couche céramique (11),
et/ou
**en ce qu'**une couche ou zone d'arrêt de soudure (23) est formée sur une partie de la couche métallique (12) de préférence sur au moins une zone structurée (12') de cette couche métallique par application et cuisson de la pâte contenant du verre, l'application de la zone d'arrêt de soudure ayant lieu par exemple conjointement avec l'application de la couche isolante (14, 14c).

12. Module, produit en utilisant un substrat métal-céramique selon l'une quelconque des revendications 1 à 9, **caractérisé en ce qu'**au moins une zone libre structurée (II) de la couche métallique du premier type forme des pistes conductrices, surfaces de contact, surfaces de montage, etc. pour au moins un composant semi-conducteur (3, 4) qui y est prévu et **en ce que** l'au moins une couche métallique (15, 15c) avec zones structurées (15') forme des pistes conductrices, surfaces de contact et/ou surfaces de montage pour au moins un composant (6) d'au moins un étage d'excitation ou de commande.
